# EUROPEAN PATENT APPLICATION

(11) **EP 4 632 396 A1**
(43) Date of publication of application: **15.10.2025**
(21) Application number: 24168914.0
(22) Date of filing: 08.04.2024
(51) Int. Cl.: G01R 31/28, G01R 31/308

(54) **MEASUREMENT SYSTEM WITH EXTERNAL OPTICAL FRONTEND**

(71) Applicant: Rohde & Schwarz GmbH & Co. KG, 81671 München (DE)
(72) Inventor: Lueck, Thorsten, 81671 München (DE); Harms, Julian, 81671 München (DE); Seeger, Julius, 81671 München (DE)
(74) Representative: Prinz & Partner mbB

(57) **Abstract**

A measurement system (10) comprising an external optical frontend (14) connectable to a separately formed measurement instrument (12) is described. The external optical frontend (14) comprises an optical test interface (16) that is connectable to a device under test. The external optical frontend (14) has an optical coupler module (26) with an optical reference input port (28) for receiving a modulated optical reference signal, at least one optical port (30) for receiving an optical measurement signal, an optical reference output port (32), and an optical measurement output port (34). The external optical frontend (14) further comprises an optical RX module (36), wherein the optical RX module (36) is connected to the optical reference output port (32) and to the optical measurement output port (34). The optical RX module (36) is configured to convert the optical measurement signal into an electrical measurement signal. The optical RX module (36) further is configured to convert the modulated optical reference signal into an modulated electrical reference signal.

## Description

The present invention generally relates to a measurement system.

With requirements on data rates becoming higher and higher, the use of optical channels for data transmission becomes increasingly more popular.

Therein, an electro-optical converter may convert an electrical data signal into an optical data signal, which enables a data transfer with high bandwidth and minimal losses.

At the target location, for example in a household, the optical data signal is converted back into an electrical data signal by an electro-optical converter.

Testing of optical devices, i.e. electro-optical, opto-electrical, or opto-optical devices, used for optical data transmission with conventional measurement instruments requires additional converter devices, as the conventional measurement instruments are restricted to measuring electrical signals.

The additional converter devices lead to a more complicated measurement setup, particularly with respect to correctly setting up connections in the measurement system.

The object of the present invention is to provide a measurement system that allows to perform measurements on optical devices with reduced effort.

According to the invention, the problem is solved by a measurement system. The measurement system comprises an external optical frontend connectable to a separately formed measurement instrument, wherein the external optical frontend has an optical coupler module. The external optical frontend comprises an optical test interface, wherein the optical test interface is connectable to a device under test, and wherein the optical test interface is configured to transmit optical signals to the device under test and receive optical signals from the device under test. The optical coupler module comprises an optical reference input port, wherein the optical coupler module is configured to receive a modulated optical reference signal from an optical signal generator module via the optical reference input port. The optical coupler module further comprises at least one optical port, wherein the at least one optical port is connected with the optical test interface, wherein the optical coupler module is configured to forward the modulated optical reference signal to the optical test interface via the at least one optical port, and wherein the optical coupler module is configured to receive an optical measurement signal from the optical test interface via the at least one optical port. The optical coupler module further comprises an optical reference output port, wherein the optical coupler module is configured to forward the modulated optical reference signal to the optical reference output port. The optical coupler module further comprises an optical measurement output port, wherein the optical coupler module is configured to forward the optical measurement signal received via the at least one optical port to the optical measurement output port. The external optical frontend further comprises an optical RX module, wherein the optical RX module is connected to the optical reference output port and to the optical measurement output port. The optical RX module is configured to convert the optical measurement signal into an electrical measurement signal. The optical RX module further is configured to convert the modulated optical reference signal into an modulated electrical reference signal.

Therein and in the following, the term "module" is understood to denote suitable hardware, suitable software, a combination of hardware and software being configured to perform the described functionality with respect to electrical signals, and/or optical components being configured to perform the described functionality with respect to optical signals.

The hardware may, inter alia, comprise a CPU, a GPU, an FPGA, an ASIC, or other types of electronic circuitry.

Further, in the context of the present disclosure, the term "forward" is understood to denote that the respective signal is transmitted between the specified components via a direct connection, such as an electrical connection or an optical fiber, or via a coupling connection such as an electromagnetic coupling in a directional coupling element. Accordingly, forwarded signals may be attenuated due to coupling characteristics of directional coupling elements.

Moreover, hereinafter the term "optical device under test" is understood to denote an opto-optical devices under test, i.e. a device under test with an optical input port and an optical output port, an electro-optical devices under test, i.e. a device under test with an electrical input port and an optical output port, or an opto-electrical device under test, i.e. a device under test with an optical input port and an electrical output port.

The measurement system according to the present invention provides a simplified measurement setup for testing optical devices under test, as all connections necessary for testing the device under test are provided by the external optical frontend.

In fact, the optical coupler module comprised in the external optical frontend provides all necessary connections for testing the optical devices under test in a highly integrated manner.

More precisely, the modulated optical reference signal can be forwarded to the optical test interface and thus to the device under test by the optical coupler module via the optical reference input port and the at least one optical port. Thus, the modulated optical reference signal can be provided to the device under test as in input signal. This connection enables testing opto-electrical devices under test or opto-optical devices under test.

The modulated optical reference signal can further be provided to the optical RX module by the optical coupler module via the optical reference input port and the optical reference output port. This connection enables measurements with the modulated optical reference signal as a reference, namely for testing opto-optical devices under test or opto-electrical devices under test.

Further, the optical measurement signal can be provided to the optical RX module by the optical coupler module via the at least one optical port and the optical measurement output port. This connection enables testing electro-optical devices under test and opto-optical devices under test.

Accordingly, all necessary optical connections for performing tests on optical devices under test are provided by the optical coupler module that is integrated into the external optical frontend, such that the measurement setup is simplified.

In fact, the measurement system according to the present invention allows for performing measurements on optical device under test with a high bandwidth, e.g. up to a bandwidth of 140 GHz or even higher.

According to an aspect of the present invention, the measurement system further comprises an electrical coupler module and a measurement module, wherein the electrical coupler module is connected to the at least one optical RX module so as to receive the electrical measurement signal and the modulated electrical reference signal, and wherein the electrical coupler module is configured to forward the electrical measurement signal and the modulated electrical reference signal to the measurement module. The measurement module may be configured to digitize and/or analyze the electrical measurement signal and/or modulated electrical reference signal.

Particularly, the measurement module may be configured to determine at least one performance parameter of the device under test based on the electrical measurement signal, particularly based on the electrical measurement signal and based on the modulated electrical reference signal. The at least one performance parameter may be indicative of a performance of the device under test, particularly with respect to signal quality, noise level, signal to noise ratio, linearity, frequency response shape, etc.

In an embodiment of the present invention, the external optical frontend comprises the electrical coupler module and/or the measurement module. Thus, the measurement setup is simplified even further, as the electrical coupler module and/or the measurement module may be provided within the external optical frontend.

Alternatively, the electrical coupler module and/or the measurement module may be integrated into a measurement instrument that is provided separately from the external optical frontend.

In general, the electrical coupler module and the measurement module may be provided within the same housing, particularly in a housing of the external optical frontend or in a housing of the measurement instrument.

According to another aspect of the present invention, the external optical frontend comprises an electrical test interface, wherein the electrical test interface is connectable to a device under test, and wherein the electrical test interface is configured to transmit electrical signals to the device under test and/or receive electrical signals from the device under test. The electrical test interface enables to perform measurements on electro-optical devices under test and/or on opto-electrical devices under test.

More precisely, providing electrical signals to the device under test enables testing electro-optical devices under test.

Receiving electrical signals from the device under test enables testing opto-electrical devices under test.

It is noted that transmitting and receiving electrical signals by the electrical test interface also allows to perform measurements on devices under test with an electrical input and an electrical output. However, this functionality usually already is provided by conventional measurement instruments, such as conventional vector network analyzers, i.e. these types of measurements could also be performed without the external optical frontend.

A further aspect of the present invention provides that the electrical coupler module is configured to forward an electrical measurement signal received by the electrical test interface to the measurement module. Thus, an electrical output signal of the device under test is forwarded to the measurement module.

Particularly, the measurement module may be configured to determine at least one performance parameter of the device under test based on the electrical measurement signal, particularly based on the electrical measurement signal and based on the modulated electrical reference signal for opto-electrical devices under test. The at least one performance parameter may be indicative of a performance of the device under test, particularly with respect to signal quality, noise levels, signal to noise ratio, linearity, frequency response shape, etc.

In a further embodiment of the present invention, the measurement system comprises an RF generator module, wherein the RF generator module is configured to generate an electrical RF signal, wherein the electrical coupler module is connected to the RF generator module so as to receive the electrical RF signal, and wherein the electrical coupler module is configured to forward the electrical RF signal to the electrical test interface. Accordingly, the electrical RF signal may be transmitted to a device under test via the electrical test interface, i.e. the electrical RF signal may serve as an input signal of the device under test.

Particularly, the device under test may be an electro-optical device that processes the electrical RF signal and generates the optical measurement signal based on the electrical RF signal. Accordingly, the electrical input signal of the device under test is output via the electrical test interface of the external optical frontend, and the optical output signal of the device under test is received via the optical test interface of the external optical frontend.

The measurement system may comprise an RF generator module, wherein the RF generator module is configured to generate an electrical RF signal, and wherein the optical signal generator module is configured to generate the modulated optical reference signal based on the RF signal. In other words, information comprised in the RF signal may be modulated onto an optical reference signal, such that the modulated optical reference signal comprises the information comprised in the RF signal.

The RF generator module may be integrated into the external optical frontend. Alternatively, the RF generator module may be integrated into a measurement instrument that is provided separately from the external optical frontend. Alternatively, the RF generator module may be provided separately from the external optical frontend and separately from the measurement instrument.

As will be described in more detail below, the RF generator module may be partially integrated into the external optical frontend, and partially integrated into the measurement instrument.

According to an aspect of the present invention, the optical signal generator module comprises a light source and a modulator module, particularly wherein the modulator module comprises a Mach-Zehnder-modulator. In general, the modulator module is configured to modulate light output by the light source, particularly based on the RF signal described above, thereby obtaining the modulated optical reference signal.

The light source may be a (coherent) light source, e.g. laser (diode) or a light emitting diode (LED), that provides the optical signal to be processed.

The light source and the modulator module may be established separately from each other.

In other words, the optical signal generator module may comprises an optical source, namely the light source, providing an optical signal and an electro-optical modulator having an input connected with the optical source. The electro-optical modulator receives via its input the optical signal provided by the optical source. The electro-optical modulator is capable of amplitude modulating the optical signal while being phase- and/or frequency-shifted, thereby generating the modulated optical reference signal. Accordingly, a dedicated electro-optical modulator is provided that is separately formed with respect to the optical source, e.g. a laser, a laser diode or a light emitting diode. The optical source outputs an optical signal that is forwarded to the electro-optical modulator which in turn modulates the optical signal received in order to generate the modulated optical reference signal.

Alternatively, the light source and the modulator module may be integrated into a common modulation device.

The common modulation device may be established by a (coherent) light source, e.g. a laser (diode) or a light-emitting diode (LED), that is configured to modulate the optical signal directly in order to output the modulated optical reference signal. For instance, an operating current of the optical signal generator module, namely of the (coherent) light source like the laser (diode), is altered, thereby generating the modulated optical reference signal. The operating current may be modulated by means of the RF signal described above. This effectively results in the same modulation scheme as the one obtained due to the optical source and the electro-optical modulator which are separately formed.

In an embodiment of the present invention, the external optical frontend comprises the RF generator module and/or the optical signal generator module. Thus, the measurement system is simplified even further, as the RF generator module and/or the optical signal generator module may be integrated into the external optical frontend.

However, it is to be understood that the RF generator module and/or the optical signal generator module may alternatively be integrated into a measurement instrument that is provided separately from the external optical frontend.

Alternatively, the RF generator module and/or the optical signal generator module may be provided separately from the external optical frontend and separately from the measurement instrument.

Alternatively, the RF generator module and/or the optical signal generator module may be partially integrated into the external optical frontend, and partially integrated into the measurement instrument.

Another aspect of the present invention provides that the external optical frontend comprises an optical reference input interface, wherein the optical reference input interface is configured to receive the modulated optical reference signal from the optical signal generator module, wherein the optical signal generator module is established separately from the external optical frontend, and wherein the optical reference input interface is connected to the optical reference input port. Accordingly, the optical signal generator module may not be integrated into the external optical frontend, but may be provided separately from the external optical frontend.

For example, the optical signal generator module may be integrated into a measurement instrument that is provided separately from the external optical frontend.

Alternatively, the optical signal generator module may be provided separately from the external optical frontend and separately from the measurement instrument.

In a further embodiment of the present invention, the measurement system comprises a measurement instrument, wherein the external optical frontend is separately formed with respect to the measurement instrument. Accordingly, the measurement instrument and the external optical frontend may comprise separately formed housings.

In general, the measurement instrument may be configured to perform measurements on electrical signals. Thus, with the measurement instrument alone, measurements may be performed on devices under test having an electrical output port, particularly an electrical output port and an electrical input port. However, together with the external optical frontend according to the present invention, measurements on different types of devices under test can be performed, namely on electro-optical devices under test, opto-electrical devices under test, opto-optical devices under test, and/or electro-electrical devices under test.

Particularly, the measurement instrument and the external optical frontend comprise a data interface, respectively, and wherein the data interface of the measurement instrument is connected with the data interface of the external optical frontend. Accordingly, data and/or signals regarding measurements performed and/or to be performed can be exchanged between the measurement instrument and the external optical frontend.

The data interface may be any suitable type of interface, e.g. a serial interface or a parallel interface.

For example, configuration parameters for performing measurements may be exchanged between the measurement instrument and the external optical frontend.

As another example, the electrical measurement signal and/or the electrical reference signal may be forwarded to the measurement instrument via the data interfaces.

In a further example, the electrical RF signal described above may be forwarded to the external optical frontend via the data interfaces.

According to an aspect of the present invention, the RF generator module is partially integrated into the measurement instrument and partially integrated into the external optical frontend. For example, the measurement instrument may comprise a first RF generator sub-module, and the external frontend may comprise a second RF generator sub-module.

Particularly, the first RF generator sub-module may be configured to generate the electrical RF signal within a first frequency range, and the second RF generator sub-module may be configured to generate the electrical RF signal within a second frequency range.

The electrical RF signal generated by the first RF generator sub-module may be forwarded to the external optical frontend via the data interfaces.

The first frequency range and the second frequency range may be different from each other, particularly overlap-free.

In fact, the first frequency range may be confined by a first lower frequency threshold and by a first upper frequency threshold. The second frequency range may be confined by a second lower frequency threshold and by a second upper frequency threshold.

The second upper frequency threshold may be larger than the first upper frequency threshold.

The second lower frequency threshold may be equal to or smaller than the first upper frequency threshold.

In a particular example, the first RF generator sub-module may generate the electrical RF signal having a frequency up to 67 GHz. The second RF generator sub-module may generate the electrical RF signal having a frequency between 67 GHz and 130 GHz or above.

According to another aspect of the present invention, the optical signal generator module is partially integrated into the measurement instrument and partially integrated into the external optical frontend.

For example, the light source described above may be integrated into the measurement instrument, while the modulator module described above may be integrated into the external optical frontend.

The measurement instrument may be a vector network analyzer.

However, it is to be understood that the measurement instrument may be established as any other suitable type of measurement instrument, e.g. as an oscilloscope, as a spectrum analyzer, or as a signal analyzer.

Another aspect of the present invention provides that the optical RX module comprises a first photo receiver unit and a second photo receiver unit, wherein the first photo receiver unit is configured to convert the optical measurement signal into the electrical measurement signal, and wherein the second photo receiver unit is configured to convert the modulated optical reference signal into the modulated electrical reference signal. Accordingly, two separate photo receiver units are provided for converting the optical measurement signal and the modulated optical reference signal into electrical signals. Thus, the optical measurement signal and the modulated optical reference signal may be converted into electrical signals simultaneously.

In an embodiment of the present invention, the optical RX module comprises a photo receiver unit and an optical switching unit, wherein the optical switching unit is configured to selectively forward the optical measurement signal or the modulated optical reference signal to the photo receiver unit. Accordingly, a single photo receiver unit may be provided that converts the optical measurement signal and the modulated optical reference signal into a respective electrical signal in an alternating manner.

The photo receiver unit(s) may, for example, be or comprise a photo diode.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a measurement system according to the present invention;
- Figure 2 schematically shows a first variant of an optical signal generator module of the measurement system of Figure 1;
- Figure 3 schematically shows a second variant of an optical signal generator module of the measurement system of Figure 1;
- Figure 4 schematically shows a first variant of an optical RX module of the measurement system of Figure 1;
- Figure 5 schematically shows a second variant of an optical RX module of the measurement system of Figure 1;
- Figures 6 to 14 schematically show different variants of an electrical coupler module of the measurement system of Figure 1;
- Figure 15 schematically shows a measurement module of the measurement system of Figure 1; and
- Figure 16 schematically shows a further variant of a measurement system according to the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

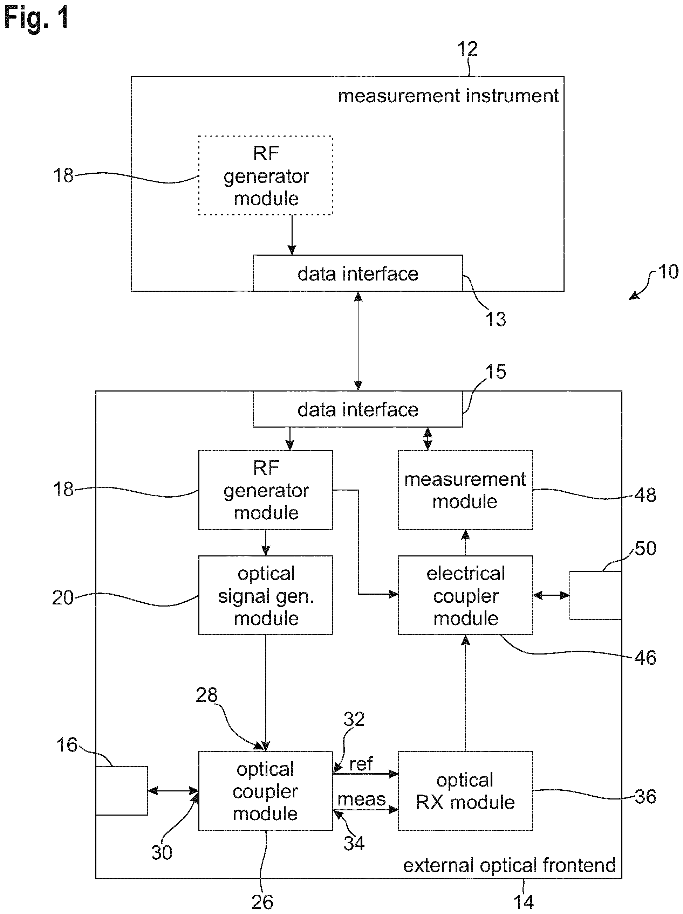

Figure 1 schematically shows a measurement system 10 comprising a measurement instrument 12 with a data interface 13 and an external optical frontend 14 with a data interface 15.

In general, the measurement instrument 12 is configured to perform measurements on electrical output signals of devices under test.

For example, the measurement instrument 12 may be established as a vector network analyzer.

However, it is to be understood that the measurement instrument 12 may be established as any other suitable type of measurement instrument.

The measurement instrument 12 and the external optical frontend 14 are established separately from each other, i.e. the measurement instrument 12 comprises a housing, and the external optical frontend 14 comprises a housing that is established separately from the housing of the measurement instrument 12.

In general, the external optical frontend 14 enables to perform measurements on different types of devices under test, namely electro-optical devices under test, opto-electrical device under test, and/or opto-optical device under test.

Further, the external optical frontend 14 may enable to perform measurements on electro-electrical devices under test.

Data and/or signals regarding measurements performed and/or to be performed can be exchanged between the measurement instrument 12 and the external optical frontend 14 via the data interfaces 13, 15.

The data interface may be any suitable type of interface, e.g. a serial interface or a parallel interface.

The external optical frontend 14 comprises an optical test interface 16, wherein the optical test interface 16 is connectable to a device under test, and wherein the optical test interface 16 is configured to transmit optical signals to the device under test and receive optical signals from the device under test.

It is emphasized that while only a single optical test interface 16 is shown in Figure 1, it is to be understood that the external optical frontend 14 may comprise a plurality of optical test interfaces.

The measurement system 10 further comprises an RF generator module 18 and an optical signal generator module 20 connected to the RF generator module 18.

In the exemplary embodiment shown in Figure 1, the RF generator module 18 and the optical signal generator module 20 are both integrated into the external optical frontend 14.

Alternatively, the RF generator module 18 and/or the optical signal generator module 20 may be integrated into the measurement instrument 12.

Alternatively, the RF generator module 18 and/or the optical signal generator module 20 may be provided separately from the measurement instrument 12 and separately from the external optical frontend 14.

According to another variant, the RF generator module 18 is partially integrated into the measurement instrument 12 and partially integrated into the external optical frontend 14.

As is indicated by the dashed lines in Figure 1, the RF generator module 18 may comprise a first RF generator sub-module that is integrated into the measurement instrument 12, and a second RF generator sub-module that is integrated into the external optical frontend 14.

Likewise, the optical signal generator module 20 may be partially integrated into the measurement instrument 12 and partially integrated into the external optical frontend 14.

In general, the RF generator module 18 is configured to generate an electrical RF signal that is forwarded to the optical signal generator module 20, and the optical signal generator module 20 is configured to generate a modulated optical reference signal based on the electrical RF signal.

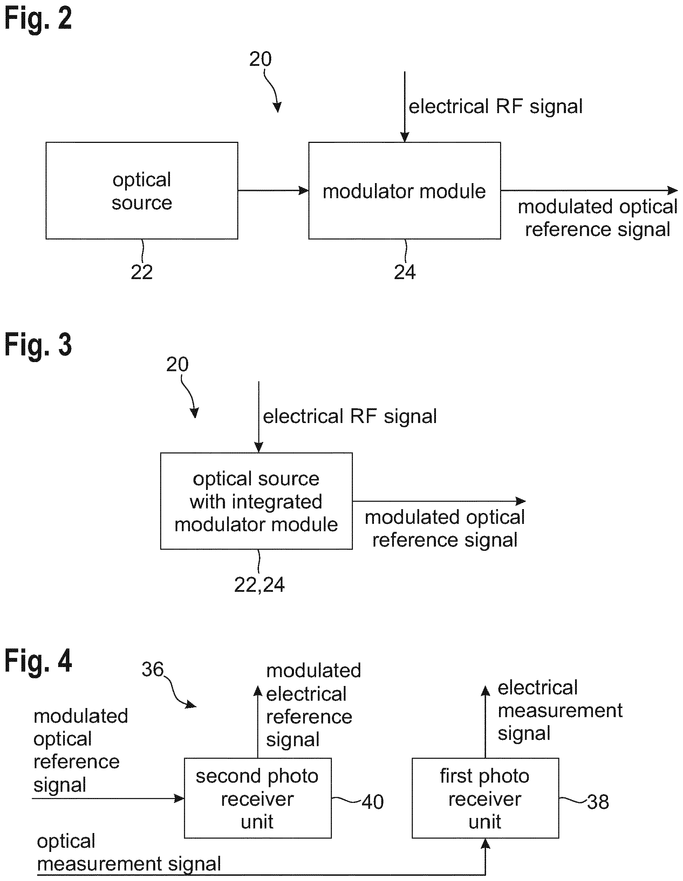

Figure 2 shows a first exemplary embodiment of the optical signal generator module 20. In this exemplary embodiment, the optical signal generator module 20 comprises an optical source 22 and a modulator module 24 that is established separately from the optical source 22.

The optical source 22 may be or comprise a coherent light source such as a laser, particularly a laser diode. In another example, the optical source 22 may be or comprise a light emitting diode (LED).

The optical source 22 generates an optical signal that is provided to the modulator module 24 being an electro-optical modulator, for example a Mach-Zehnder-modulator.

The modulator module 24 modulates the optical signal based on the electrical RF signal received from the RF generator module 18, thereby obtaining the modulated optical reference signal.

If the optical signal generator module 20 is partially integrated into the measurement instrument 12 and partially integrated into the external optical frontend 14, the optical source 22 may be integrated into the measurement instrument 12, while the modulator module 24 may be integrated into the external optical frontend 14. The optical signal generated by the optical source 22 may be forwarded to the modulator module 24 via optical interfaces of the measurement instrument 12 and of the external optical frontend 14.

Figure 3 shows a second exemplary embodiment of the optical signal generator module 20, wherein the optical source 22 and the modulator module 24 are integrated into a common modulation device.

The common modulation device may be established by a coherent light source, e.g. a laser (diode) or a light-emitting diode (LED), that is configured to modulate the optical signal directly based on the electrical RF signal in order to generate and output the modulated optical reference signal.

Referring back to Figure 1, the external optical frontend 14 further comprises an optical coupler module 26 that is connected to the optical signal generator module 20 and to the optical test interface 16, respectively.

In fact, the optical coupler module 26 comprises an optical reference input port 28, at least one optical port 30, an optical reference output port 32, and an optical measurement output port 34.

The optical reference input port 28 is connected to the optical signal generator module 20 so as to receive the modulated optical reference signal.

The at least one optical port 30 is connected with the optical test interface 16.

The optical coupler module 26 is configured to forward the modulated optical reference signal to the at least one optical port 30, such that the modulated optical reference signal is forwarded to the optical test interface 16. Accordingly, the modulated optical reference signal can be forwarded to a device under test that is connected to the optical test interface 16.

Moreover, the optical coupler module 26 is configured to forward the modulated optical reference signal to the optical reference output port 32.

Further, an optical measurement signal may be received by the optical test interface 16 from a device under test, which is forwarded to the at least one optical port 30.

The optical coupler module 26 is configured to forward the optical measurement signal to the optical measurement output port 34.

The external optical frontend 14 further comprises an optical RX module 36 that is connected to the optical coupler module 26 downstream of the optical coupler module 26.

More precisely, the optical RX module 36 is connected to the optical reference output port 32 and to the optical measurement output port 34 so as to receive the modulated optical reference signal and the optical measurement signal, respectively.

Figure 4 shows a first exemplary embodiment of the optical RX module 36.

In this exemplary embodiment, the optical RX module 36 comprises a first photo receiver unit 38 that is connected to the optical measurement output port 34 so as to receive the optical measurement signal.

The first photo receiver unit 38 is configured to convert the optical measurement signal into a corresponding electrical measurement signal.

For example, the first photo receiver unit 38 may be or comprise a photo diode.

In the exemplary embodiment of Figure 4, the optical RX module 36 further comprises a second photo receiver unit 40 that is connected to the optical reference output port 34 so as to receive the modulated optical reference signal.

The second photo receiver unit 40 is configured to convert the modulated optical reference signal into a corresponding modulated electrical measurement signal.

For example, the second photo receiver unit 40 may be or comprise a photo diode.

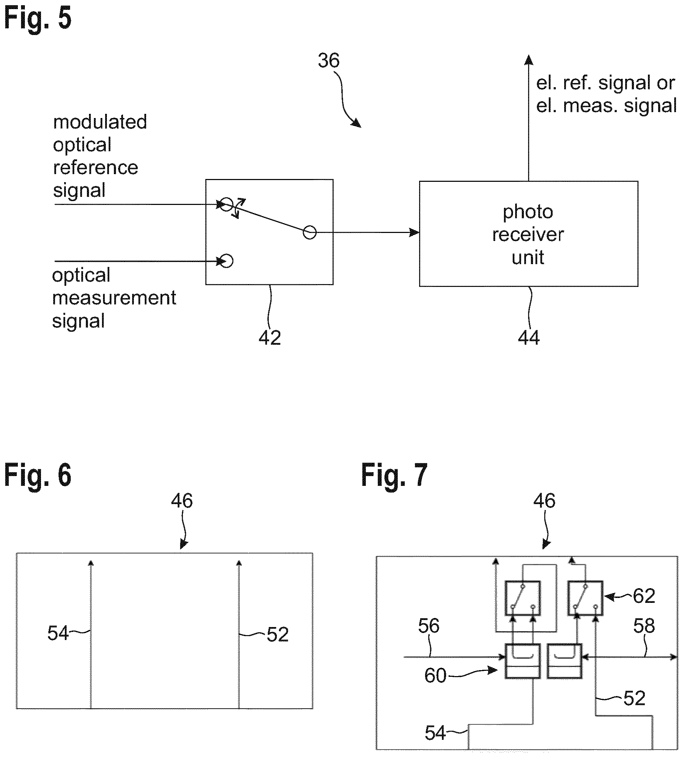

Figure 5 shows a second exemplary embodiment of the optical RX module 36.

In this exemplary embodiment, the optical RX module comprises an optical switching unit 42 and a photo receiver unit 44.

The optical switching unit 42 is configured to selectively forward the optical measurement signal or the modulated optical reference signal to the photo receiver unit 44, particularly in an alternating manner.

Accordingly, the photo receiver unit 44 may alternately convert the optical measurement signal into the electrical measurement signal and the modulated optical reference signal into the modulated electrical reference signal.

For example, the photo receiver unit 44 may be or comprise a photo diode.

Referring back to Figure 1, the external optical frontend 14 may further comprise an electrical coupler module 46 that is provided downstream of the optical RX module 36 so as to receive the electrical measurement signal and the modulated electrical reference signal from the optical RX module 36.

It is noted that the electrical coupler module 46 may comprise one or several mixing unit(s) that is/are configured to down-convert the modulated electrical reference signal and/or the electrical measurement signal in frequency, namely from RF frequency to an intermediate frequency.

The electrical coupler module 46 may further be connected to the RF generator module 18 so as to receive the electrical RF signal from the RF signal generator module 18.

The external optical frontend 14 further comprises a measurement module 48 and, optionally, an electrical test interface 50.

In general, the electrical test interface 50 is connectable to a device under test, wherein the electrical test interface 50 is configured to transmit electrical signals to the device under test and/or receive electrical signals from the device under test.

It is emphasized that while only a single electrical test interface 50 is shown in Figure 1, it is to be understood that the external optical frontend 14 may comprise a plurality of electrical test interfaces.

The electrical coupler module 46 is configured to forward the electrical RF signal to the electrical test interface 50 and/or to the measurement module 48.

Accordingly, the electrical RF signal can be forwarded to a device under test connected to the electrical test interface 50 via the electrical coupler module 46 and the electrical test interface 50.

Further, the electrical coupler module 46 may be configured to forward an electrical measurement signal received by the electrical test interface 50 from a device under test to the measurement module 48.

Alternatively or additionally, the electrical coupler module 46 may be configured to forward the electrical measurement signal and/or the modulated electrical reference signal received from the optical RX module 36 to the measurement module 48.

Figure 6 shows an exemplary embodiment of the electrical coupler module 46. In this exemplary embodiment, the electrical coupler module 46 comprises a first electrical connection 52 and a second electrical connection 54.

The first electrical connection 52 is configured to forward the electrical measurement signal from the optical RX module 36 to the measurement module 48.

Particularly, the first electrical connection 52 may be connected with the first photo receiver unit 38 shown in Figure 4.

The second electrical connection 54 is configured to forward the modulated electrical reference signal from the optical RX module 36 to the measurement module 48.

Particularly, the second electrical connection 54 may be connected with the second photo receiver unit 40 shown in Figure 4.

Figure 7 shows a further exemplary embodiment of the electrical coupler module 46. In this exemplary embodiment, the electrical coupler module 46 further comprises a third electrical connection 56 and a fourth electrical connection 58.

The third electrical connection 56 is connected with the RF generator module 18 so as to receive the electrical RF signal.

The fourth electrical connection 58 is connected with the electrical test interface 50.

The electrical coupler module 46 further comprises a directional circuit 60 and a switching circuit 62.

In the exemplary embodiment shown in Figure 7, the directional circuit 60 and the switching circuit 62 are configured to selectively forward the electrical measurement signal and the modulated electrical reference signal from the optical RX module 36 to the measurement module 48 (for testing opto-optical devices under test), the electrical RF signal received from the RF generator module 18 and an electrical measurement signal received from the electrical test interface 50 to the measurement module 48 as well as the electrical RF signal to the electrical test interface 50 (for testing electro-electrical devices under test), the electrical RF signal received from the RF generator module 18 and the optical measurement signal received from the optical RX module 36 to the measurement module 48 as well as the electrical RF signal to the electrical test interface 50 (for testing electro-optical devices under test), or the modulated optical reference signal received from the optical RX module 36 and the electrical measurement signal received from the electrical test interface 50 to the measurement module 48 (for testing opto-electrical devices under test).

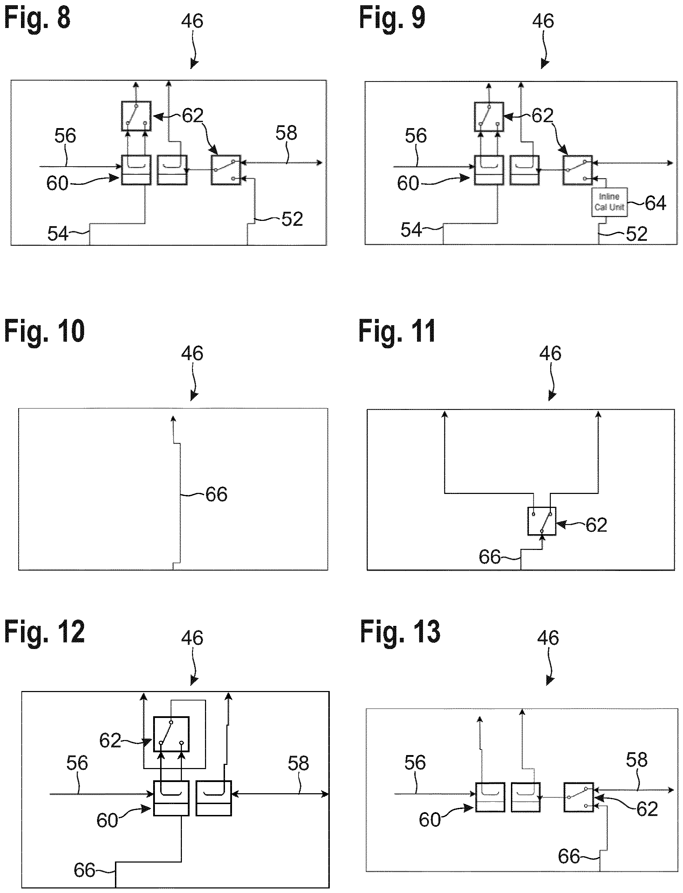

Figure 8 shows another exemplary embodiment of the electrical coupler module 46.

In the exemplary embodiment of Figure 8, the directional circuit 60 and the switching circuit 62 are configured to selectively forward the electrical measurement signal and the modulated electrical reference signal from the optical RX module 36 to the measurement module 48 in an alternating manner (for testing opto-optical devices under test), the electrical RF signal received from the RF generator module 18 and an electrical measurement signal received from the electrical test interface 50 to the measurement module 48 as well as the electrical RF signal to the electrical test interface 50 (for testing electro-electrical devices under test), the electrical RF signal received from the RF generator module 18 and the optical measurement signal received from the optical RX module 36 to the measurement module 48 as well as the electrical RF signal to the electrical test interface 50 (for testing electro-optical devices under test), or the modulated optical reference signal received from the optical RX module 36 and the electrical measurement signal received from the electrical test interface 50 to the measurement module 48 in an alternating manner (for testing opto-electrical devices under test).

Figure 9 shows a further exemplary embodiment of the electrical coupler module 46. Compared to the embodiment of Figure 8, the electrical coupler module 46 further comprises an inline calibration unit 64 that is connected to the first electrical connection 52 and the switching circuit 62.

In general, the calibration unit 64 may be used in order to calibrate the external optical frontend 14.

For example, the calibration unit 64 may comprise at least three different calibration standards that are selectively connectable to the first electrical connection 52 and the switching circuit 62, i.e. the at least three different calibration standards may be connected to the switching circuit 62 sequentially.

In a particular example, the at least three different calibration standards may comprise an "open" calibration standards, a "short" calibration standard, and a "matched" calibration standard, which is also known as "load" calibration standard.

The calibration unit 64 may have a bypass mode, wherein the calibration unit 64 provides a direct electrical connection between the first electrical connection 52 and the switching circuit 62 in the bypass mode.

Figure 10 shows another embodiment of the electrical coupler module 46. In this exemplary embodiment, the electrical coupler module 46 comprises a single electrical connection 66.

The electrical connection 66 is configured to forward the electrical measurement signal or the modulate electrical reference signal from the optical RX module 36 to the measurement module 48, particularly in an alternating manner.

In fact, the electrical connection 66 may be connected with the photo receiver unit 44 shown in Figure 5.

Figure 11 shows another embodiment of the electrical coupler module 46. Compared to the embodiment of Figure 10, the electrical coupler module 46 further comprises a switching circuit 62.

Like in the embodiment of Figure 10, the electrical coupler module 46 is configured to forward the electrical measurement signal or the modulated electrical reference signal from the optical RX module 36 to the measurement module 48, particularly in an alternating manner.

The switching circuit 62 may be configured to forward the electrical measurement signal and the modulate electrical reference signal to different submodules of the measurement module 48.

Figure 12 shows a further embodiment of the electrical coupler module 46. In this exemplary embodiment, the electrical coupler module 46 comprises the electrical connection 66, a directional circuit 60, a switching circuit 62, as well as the third electrical connection 56 and the fourth electrical connection 58 described above.

The directional circuit 60 and the switching circuit 62 are configured to selectively forward the electrical measurement signal and the modulated electrical reference signal from the optical RX module 36 to the measurement module 48 in an alternating manner (for testing opto-optical devices under test), the electrical RF signal received from the RF generator module 18 and an electrical measurement signal received from the electrical test interface 50 to the measurement module 48 as well as the electrical RF signal to the electrical test interface 50 (for testing electro-electrical devices under test), the electrical RF signal received from the RF generator module 18 and the optical measurement signal received from the optical RX module 36 to the measurement module 48 as well as the electrical RF signal to the electrical test interface 50 (for testing electro-optical devices under test), or the modulated optical reference signal received from the optical RX module 36 and the electrical measurement signal received from the electrical test interface 50 to the measurement module 48 in an alternating manner (for testing opto-electrical devices under test).

Figure 13 shows another exemplary embodiment of the electrical coupler module 46.

Like in the embodiment of Figure 12, the directional circuit 60 and the switching circuit 62 are configured to selectively forward the electrical measurement signal and the modulated electrical reference signal from the optical RX module 36 to the measurement module 48 in an alternating manner (for testing opto-optical devices under test), the electrical RF signal received from the RF generator module 18 and an electrical measurement signal received from the electrical test interface 50 to the measurement module 48 as well as the electrical RF signal to the electrical test interface 50 (for testing electro-electrical devices under test), the electrical RF signal received from the RF generator module 18 and the optical measurement signal received from the optical RX module 36 to the measurement module 48 as well as the electrical RF signal to the electrical test interface 50 (for testing electro-optical devices under test), or the modulated optical reference signal received from the optical RX module 36 and the electrical measurement signal received from the electrical test interface 50 to the measurement module 48 in an alternating manner (for testing opto-electrical devices under test).

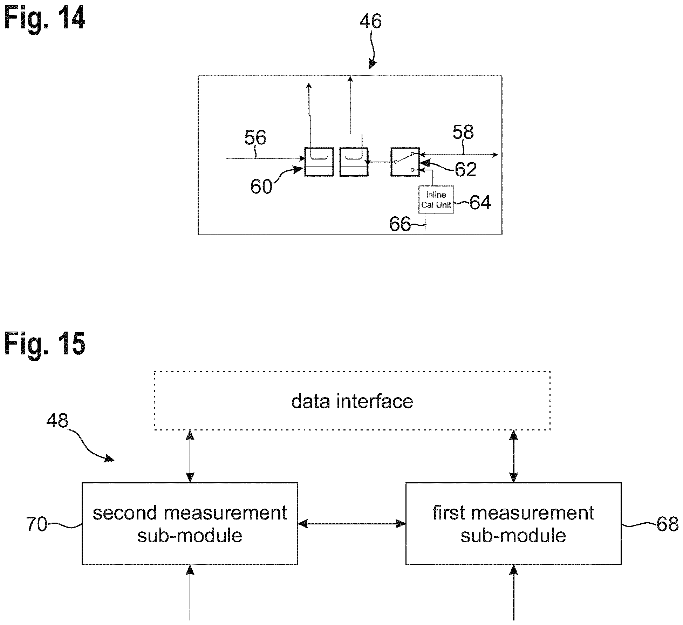

Figure 14 shows a further exemplary embodiment of the electrical coupler module 46. Compared to the embodiment of Figure 13, the electrical coupler module 46 further comprises an inline calibration unit 64 that is connected to the electrical connection 66 and the switching circuit 62.

The inline calibration unit 64 may be configured as described above with reference to Figure 9.

Summarizing, the electrical coupler module 46 may forward the electrical measurement signal and the modulated electrical reference signal from the optical RX module 36 to the measurement module 48 simultaneously. This way, an opto-optical device under test connected to the optical test interface 16 can be tested.

According to another variant, the electrical coupler module 46 may forward the electrical measurement signal and the modulated electrical reference signal from the optical RX module 36 to the measurement module 48 in an alternating manner. This way, an opto-optical device under test connected to the optical test interface 16 can be tested.

In a further variant, the electrical coupler module 46 may forward the electrical measurement signal from the electrical test interface 50 to the measurement module 48, as well as the electrical RF signal from the RF generator module 18 to the measurement module 48 and to the electrical test interface 50. This way, an electro-electrical device under test connected to the electrical test interface 50 can be tested.

In another variant, the electrical coupler module 46 may forward the electrical measurement signal from the electrical test interface 50 to the measurement module 48, as well as the modulated optical reference signal to the measurement module 48. This way, an opto-electrical device under test can be tested, wherein an input of the opto-electrical device under test is connected to the optical test interface 16, and an output of the opto-electrical device under test is connected to the electrical test interface 50.

According to another variant, the electrical coupler module 46 may forward the electrical measurement received from the optical RX module 36 to the measurement module 48, as well as the electrical RF signal received from the RF generator module 18 to the measurement module 48 and to the electrical test interface 50. This way, an electro-optical device under test can be tested, wherein an input of the electro-optical device under test is connected to the electrical test interface 50, and wherein an output of the electro-optical device under test is connected to the optical test interface 16.

As is illustrated in Figure 15, the measurement module 48 may comprise a first measurement sub-module 68 that is configured to receive and process the electrical measurement signal received from the optical RX module 36 or from the electrical test interface 50.

In general, the first measurement sub-module 68 is configured to digitize and/or analyze the electrical measurement signal received from the optical RX module 36 or from the electrical test interface 50.

The measurement module 48 may further comprise a second measurement sub-module 70 that is configured to receive and process the modulated electrical reference signal received from the optical RX module 36 or the electrical RF signal from the RF generator module 18.

In general, the second measurement sub-module 70 is configured to digitize and/or analyze the modulated electrical reference signal received from the optical RX module 36 or the electrical RF signal from the RF generator module 18.

In fact, the measurement module 48 may be configured to determine at least one performance parameter of an opto-optical device under test connected to the optical test interface 16 based on the electrical measurement signal received from the optical RX module 36 and based on the modulated electrical reference signal received from the optical RX module 36.

Further, the measurement module 48 may be configured to determine at least one performance parameter of an electro-electrical device under test connected to the electrical test interface 50 based on the electrical measurement signal received from the electrical test interface 50 and based on the electrical RF signal received from the RF generator module 18.

Moreover, the measurement module 48 may be configured to determine at least one performance parameter of an electro-optical device under test connected to the electrical test interface 50 and the optical test interface 16 based on the electrical measurement signal received from the optical RX module 36 and based on the electrical RF signal received from the RF generator module 18, wherein the electrical RF signal may serve as a reference signal.

Further, the measurement module 48 may be configured to determine at least one performance parameter of an opto-electrical device under test connected to the optical test interface 16 and to the electrical test interface 50 based on the electrical measurement signal received from the electrical test interface 50 and based on the modulated electrical reference signal received from the optical RX module 36.

The at least one performance parameter may be indicative of a performance of the device under test, particularly with respect to signal quality, noise levels, signal to noise ratio, linearity, frequency response shape, etc.

Accordingly, the measurement system 10 described above allows to test a plurality of different types of devices under test.

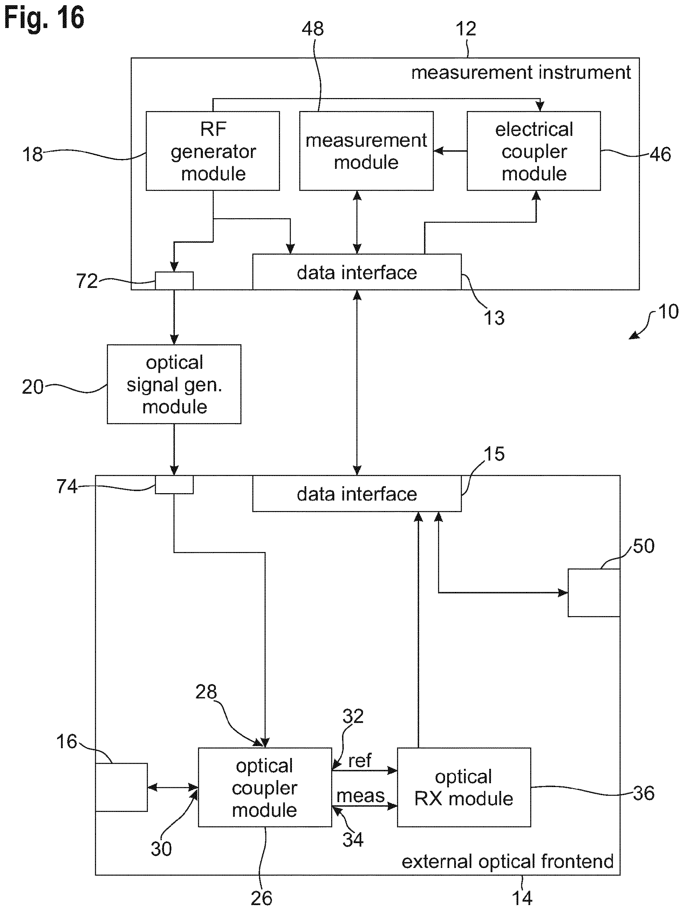

Figure 16 schematically shows a further variant of the measurement system 10, wherein only the differences compared to the first variant described above are explained hereinafter.

In fact, it is to be understood that further embodiments of the measurement system 10 are possible, wherein only one or several of the changes described hereinafter compared to Figure 1 are realized.

The RF generator module 18 may be integrated into the measurement instrument 12.

The measurement instrument 12 may further comprise an RF output 72 that is connected to the RF generator module 18 so as to receive the electrical RF signal.

In the exemplary embodiment shown in Figure 16, the optical signal generator module 20 is established separately from the measurement instrument 12 and separately from the external optical frontend 14.

The optical signal generator module 20 is connected to the RF output 72 so as to receive the electrical RF signal from the RF generator module 18.

The external optical frontend 14 further comprises an optical reference input interface 74 that is connected to the optical signal generator module 20 and to the optical reference input port 28, such that the modulated optical reference signal is forwarded to the optical reference input port 28 via the optical reference input interface 74.

Further, compared to the embodiment of Figure 1, the electrical coupler module 46 and the measurement module 48 are integrated into the measurement instrument 12.

Accordingly, the modulated electrical reference signal and/or the electrical measurement signal may be forwarded from the optical RX module 36 to the electrical coupler module 46 via the data interfaces 13, 15.

Likewise, the electrical measurement signal may be forwarded from the electrical test interface 50 to the electrical coupler module 46 via the data interfaces 13, 15.

Further, the electrical RF signal may be forwarded from the electrical coupler module 46 to the electrical test interface 50 via the data interfaces 13, 15, or directly from the RF generator module 18 via the data interfaces 13, 15 to the electrical test interface 50.

Further, it noted that both the measurement instrument 12 and the external optical frontend 14 may comprise an electrical coupler module and/or a measurement module.

If both the measurement instrument 12 and the external optical frontend 14 comprise an electrical coupler module, the electrical coupler module of the measurement instrument 12 may be by-passed.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A measurement system, wherein the measurement system (10) comprises an external optical frontend (14) connectable to a separately formed measurement instrument (12), wherein the external optical frontend (14) has an optical coupler module (26),
wherein the external optical frontend (14) comprises an optical test interface (16), wherein the optical test interface (16) is connectable to a device under test, and wherein the optical test interface (16) is configured to transmit optical signals to the device under test and receive optical signals from the device under test,
wherein the optical coupler module (26) comprises an optical reference input port (28), wherein the optical coupler module (26) is configured to receive a modulated optical reference signal from an optical signal generator module (20) via the optical reference input port (28),
wherein the optical coupler module (26) further comprises at least one optical port (30), wherein the at least one optical port (30) is connected with the optical test interface (16), wherein the optical coupler module (26) is configured to forward the modulated optical reference signal to the optical test interface (16) via the at least one optical port (30), and wherein the optical coupler module (26) is configured to receive an optical measurement signal from the optical test interface (16) via the at least one optical port (30),
wherein the optical coupler module (26) further comprises an optical reference output port (32), wherein the optical coupler module (26) is configured to forward the modulated optical reference signal to the optical reference output port (32),
wherein the optical coupler module (26) further comprises an optical measurement output port (34), wherein the optical coupler module (26) is configured to forward the optical measurement signal received via the at least one optical port (30) to the optical measurement output port (34), and
wherein the external optical frontend (14) further comprises an optical RX module (36), wherein the optical RX module (36) is connected to the optical reference output port (32) and to the optical measurement output port (34), wherein the optical RX module (36) is configured to convert the optical measurement signal into an electrical measurement signal, and wherein the optical RX module (36) is configured to convert the modulated optical reference signal into an modulated electrical reference signal.

2. The measurement system of claim 1, wherein the measurement system (10) further comprises an electrical coupler module (46) and a measurement module (48), wherein the electrical coupler module (46) is connected to the at least one optical RX module (36) so as to receive the electrical measurement signal and the modulated electrical reference signal, and wherein the electrical coupler module (46) is configured to forward the electrical measurement signal and the modulated electrical reference signal to the measurement module (48).

3. The measurement system of claim 2, wherein the external optical frontend (14) comprises the electrical coupler module (46) and/or the measurement module (48).

4. The measurement system of claim 3, wherein the external optical frontend (14) comprises an electrical test interface (50), wherein the electrical test interface (50) is connectable to a device under test, and wherein the electrical test interface (50) is configured to transmit electrical signals to the device under test and/or receive electrical signals from the device under test.

5. The measurement system of claim 4, wherein the electrical coupler module (46) is configured to forward an electrical measurement signal received by the electrical test interface (50) to the measurement module (48).

6. The measurement system of claim 4 or 5, wherein the measurement system (10) comprises an RF generator module (18), wherein the RF generator module (18) is configured to generate an electrical RF signal, wherein the electrical coupler module (46) is connected to the RF generator module (18) so as to receive the electrical RF signal, and wherein the electrical coupler module (46) is configured to forward the electrical RF signal to the electrical test interface (50).

7. The measurement system according to any one of the preceding claims, wherein the measurement system (10) comprises an RF generator module (18), wherein the RF generator module (18) is configured to generate an electrical RF signal, and wherein the optical signal generator module (20) is configured to generate the modulated optical reference signal based on the RF signal.

8. The measurement system of claim 7, wherein the optical signal generator module (20) comprises a light source and a modulator module (24), particularly wherein the modulator module (24) comprises a Mach-Zehnder-modulator.

9. The measurement system according to any one of claims 6 to 8, wherein the external optical frontend (14) comprises the RF generator module (18) and/or the optical signal generator module (20).

10. The measurement system according to any one of claims 1 to 8, wherein the external optical frontend (14) comprises an optical reference input interface (74), wherein the optical reference input interface (74) is configured to receive the modulated optical reference signal from the optical signal generator module (20), wherein the optical signal generator module (20) is established separately from the external optical frontend (14), and wherein the optical reference input interface (74) is connected to the optical reference input port (28).

11. The measurement system according to any one of the preceding claims, wherein the measurement system (10) comprises a measurement instrument (12), and wherein the external optical frontend (14) is separately formed with respect to the measurement instrument (12).

12. The measurement system according to claim 11, wherein the measurement instrument (12) and the external optical frontend (14) comprise a data interface (13, 15), respectively, and wherein the data interface (13) of the measurement instrument (12) is connected with the data interface (15) of the external optical frontend (14).

13. The measurement system according to any one of claims 6 to 8 in combination with claim 11 or 12, wherein the RF generator module (18) is partially integrated into the measurement instrument (12) and partially integrated into the external optical frontend (14), and/or wherein the optical signal generator module (20) is partially integrated into the measurement instrument (12) and partially integrated into the external optical frontend (14).

14. The measurement system according to any one of claims 11 to 13, wherein the measurement instrument (12) is a vector network analyzer.

15. The measurement system according to any one of the preceding claims, wherein the optical RX module (36) comprises a first photo receiver unit (38) and a second photo receiver unit (40), wherein the first photo receiver unit (38) is configured to convert the optical measurement signal into the electrical measurement signal, and wherein the second photo receiver unit (40) is configured to convert the modulated optical reference signal into the modulated electrical reference signal.

16. The measurement system according to any one of claims 1 to 13, wherein the optical RX module (36) comprises a photo receiver unit (44) and an optical switching unit (42), wherein the optical switching unit (42) is configured to selectively forward the optical measurement signal or the modulated optical reference signal to the photo receiver unit (44).
